# FASCICULE DE BREVET EUROPEEN

(11) **EP 3 562 171 B1**
(45) Date de publication et mention de la délivrance du brevet: **15.09.2021**
(21) Numéro de dépôt: 19170420.4
(22) Date de dépôt: 19.04.2019
(51) Int. Cl.: H04Q 1/02

(54) **MODULE INTELLIGENT POUR PANNEAU D'ARMOIRE DE BRASSAGE RECEVANT DES CABLES DE TRANSFERT DE DONNEES**
INTELLIGENT SCHALTTAFELMODULE ZUM EMPFANG VON KABELN FÜR DATENÜBERTRAGUNG
SMART PATCH PANEL MODULE RECEIVING CABLES FOR DATA TRANSFER

(30) Priorité: 23.04.2018 FR 1853545
(43) Date de publication de la demande: 30.10.2019
(73) Titulaire: Schneider Electric Industries SAS, 92500 Rueil Malmaison (FR)
(72) Inventeur: ISSIAKHEM, Younes, 38050 Grenoble Cedex 9 (FR); MASSE, Dominique, 38050 Grenoble Cedex 9 (FR); CHAUVIN, Cédric, 38050 Grenoble Cedex 9 (FR); MURALI, Deepak Vinjamoor, 38050 Grenoble Cedex 9 (FR)
(74) Mandataire: Brevalex

(56) Documents cités:
- US-A1- 2003 073 343
- US-A1- 2011 229 102
- US-A1- 2013 234 725

## Description

### DOMAINE TECHNIQUE

L'invention concerne une armoire de brassage du type utilisé dans les centres de données, c'est-à-dire comportant deux montants latéraux portant plusieurs panneaux recevant chacun des câbles de transfert de données, et un gestionnaire central qui est relié à chaque panneau et à un système externe de supervision. De tels systèmes sont typiquement utilisés dans les centres de données pour assurer le multiplexage de connexions réseau sur les différents ports des panneaux.

### ÉTAT DE LA TECHNIQUE ANTÉRIEURE

Dans un tel système, la partie avant de chaque panneau comporte au moins des ports pour recevoir les connecteurs et les câbles de transfert de données. C'est le cas des systèmes dits passifs, c'est-à-dire relativement anciens et dépourvus d'éléments additionnels tels que des capteurs de présence ou des diodes.

Dans de tels systèmes plus récents, dits intelligents, chaque panneau comporte en plus de ses ports de connexion, un composant électronique additionnel communiquant avec le gestionnaire central, et comportant pour chaque port un capteur de présence et une diode. Un exemple d'un tel système est divulgué par le document US2013/234725, Enge Ryan, publié le 12 Septembre 2013.

Chaque capteur de présence détecte l'état occupé ou libre du port auquel il est associé, selon qu'un connecteur est ou non présent dans ce port, et cette information est transmise au gestionnaire central.

Chaque diode est illuminée d'une couleur donnée correspondant à l'application du port auquel elle est associée, l'information de la couleur étant transmise par le gestionnaire central. Les correspondances sont par exemple bleu pour une connexion internet, rouge pour un flux de données de télévision, jaune pour un flux video et ivoire pour des communications téléphoniques.

Pour mettre en œuvre un système de type intelligent, il est possible de s'équiper d'armoires de brassage actuelles intelligentes disponibles dans le commerce, ce qui peut induire un coût significatif.

Une autre possibilité consiste à ajouter à chaque panneau passif d'armoires existantes un module additionnel équipé de capteurs et de diodes, et un gestionnaire central à chaque armoire. Cette autre possibilité est envisageable lorsque les panneaux du système passif existant étaient conçus pour recevoir un module additionnel. Mais cette possibilité n'existe pas pour les panneaux passifs dits standard, c'est-à-dire qui n'avaient pas initialement été conçus pour recevoir un module additionnel spécifique.

Le but de l'invention est d'apporter une solution permettant d'ajouter un composant additionnel intelligent à un panneau standard, afin de le transformer en panneau intelligent à moindre coût.

### EXPOSÉ DE L'INVENTION

A cet effet, l'invention a pour objet un module intelligent destiné à équiper un panneau passif porté par deux montants latéraux d'une armoire de brassage, le panneau passif comportant une face avant pourvue de ports de connexion, ce module comprenant un corps en forme de réglette ainsi que deux pattes de fixation, le corps comportant une série de diodes et une série de capteurs de présence, chaque patte de fixation comportant au moins un trou permettant de la fixer rigidement à un montant au moyen d'une vis, chaque extrémité du corps étant rigidement solidarisable à une patte de fixation en étant enserré et/ou encliqueté par cette patte.

Avec cet agencement, le corps de module intelligent peut être monté sur tout panneau standard du fait qu'il est uniquement maintenu par ses extrémités directement fixées aux montants latéraux de l'armoire. Il peut ainsi être positionné de façon adéquate, de telle sorte que ses diodes et capteurs soient au droit des ports du panneau standard, pour les surplomber tout en les laissant dégagés pour permettre la connexion et la déconnexion de câbles de transfert de données.

L'invention concerne également un module ainsi défini, dans lequel chaque patte comporte une base prolongée d'une part par deux ailes formant une pince pour enserrer une extrémité du corps et d'autre part par une languette s'étendant en direction opposée aux ailes par rapport à la base en étant perpendiculaire aux ailes et à la base, cette languette comportant au moins un trou de fixation.

L'invention concerne également un module ainsi défini, dans lequel au moins une aile comporte au moins une fenêtre d'encliquetage, et dans lequel une face du corps est pourvue d'un ergot s'engageant dans cette fenêtre pour assurer un encliquetage de la patte sur l'extrémité du corps.

L'invention concerne également un module ainsi défini, dans lequel le corps comporte à l'une de ses faces un connecteur destiné à recevoir un câble de transfert de données et d'alimentation électrique.

L'invention concerne également un module ainsi défini, dans lequel le connecteur est destiné à recevoir un câble plat du type nappe de conducteurs électriques.

L'invention concerne également un module ainsi défini, comportant un corps associé avec plusieurs paires de pattes de fixation de formes différentes pour permettre son montage selon différentes configurations.

L'invention concerne également un système intelligent pour armoire de brassage comprenant plusieurs modules ainsi définis et un gestionnaire central destiné à être connecté à chaque module.

### BRÈVE DESCRIPTION DES DESSINS

La figure 1 est une vue en perspective du module intelligent selon l'invention ;
La figure 2 est une vue en perspective d'un panneau passif équipé du module intelligent selon l'invention ;
La figure 3 est une vue en perspective d'une patte de fixation d'une extrémité du module intelligent selon l'invention à une armoire ;
La figure 4 est une vue en perspective d'une extrémité de module intelligent selon l'invention avant encliquetage dans sa patte de fixation ;
La figure 5 est une vue en perspective d'une extrémité de module intelligent selon l'invention encliqueté dans sa patte de fixation ;
La figure 6 est une vue en perspective d'une extrémité de module intelligent selon l'invention représenté seul montrant son branchement à un gestionnaire central ;
La figure 7 est une vue en perspective d'une extrémité de module selon l'invention représenté installé sur une armoire et montrant son branchement à un gestionnaire central ;
La figure 8 est une vue en perspective d'un autre montage du module intelligent selon l'invention ;
La figure 9 est une vue en perspective d'un panneau passif équipé selon l'autre montage du module intelligent selon l'invention ;
La figure 10 est une vue en perspective d'une patte de fixation d'une extrémité selon l'autre montage du module intelligent selon l'invention à une armoire ;
La figure 11 est une vue en perspective d'une extrémité de module intelligent selon l'invention avant encliquetage dans sa patte de fixation selon l'autre montage ;
La figure 12 est une vue en perspective d'une extrémité de module intelligent selon l'invention encliqueté dans sa patte de fixation selon l'autre montage.

### EXPOSÉ DÉTAILLÉ DE MODES DE RÉALISATION PARTICULIERS

L'idée à la base de l'invention est de concevoir un module pouvant être monté sur tous les panneaux passifs standard qu'ils aient ou non été prévus pour être équipés d'un module intelligent.

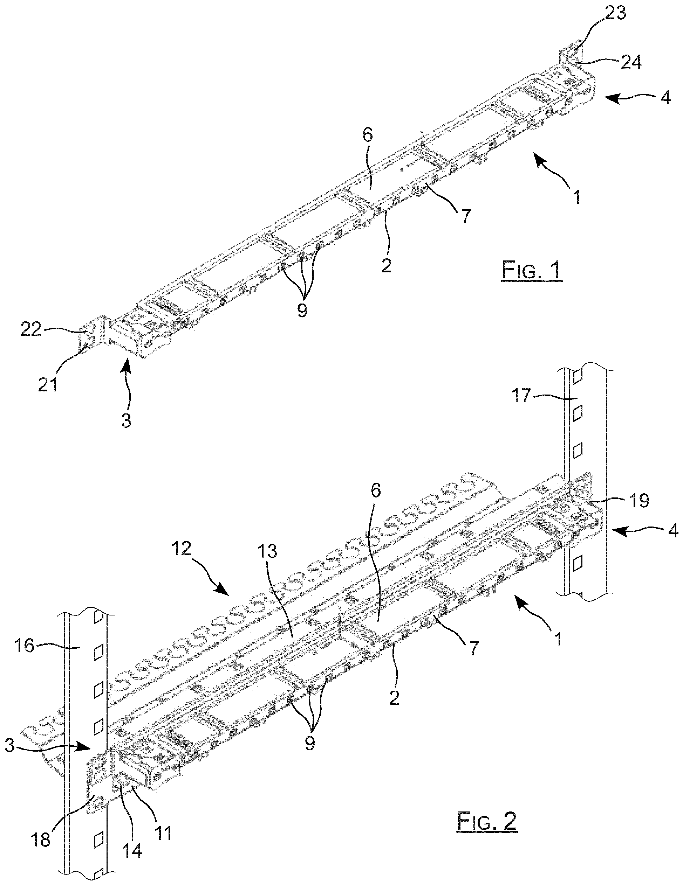

Le module selon l'invention qui est représenté sur la figure 1 où il est repéré par 1 comporte un corps principal 2 de forme généralement parallélépipédique, qui est équipé à chacune de ses extrémités d'une patte de fixation, ces pattes étant repérées par 3 et 4.

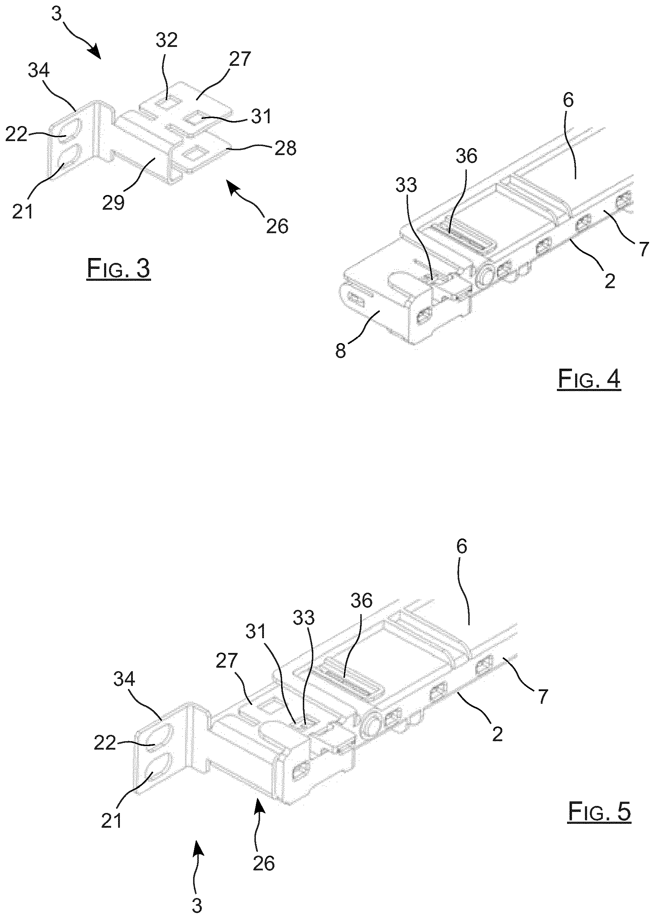

Ce corps 2 en forme de réglette comporte une face supérieure 6 et une face avant 7, visibles sur les figures, ainsi qu'une face inférieure opposée à la face supérieure 6 et une face arrière opposée à la face avant 7. Ces quatre faces principales sont réunies par deux faces latérales dont l'une, repérée par 8 est visible sur la figure 4.

Le corps 2 qui est ici au standard dit dix-neuf pouces comporte une série de vingt-quatre diodes repérées par 9 qui affleurent à sa face avant 7 en étant régulièrement espacées le long de celle-ci, et il intègre une série de vingt-quatre capteurs de présence non visibles qui sont orientés vers sa face inférieure.

Comme représenté sur la figure 2, ce module 1 est conçu pour être accolé à la partie supérieure d'une face avant 11 d'un panneau passif standard 12 de façon à le compléter.

Lorsque le module est en place, comme sur la figure 2, sa face arrière longe une région supérieure de la face avant 11 du module standard, cette face avant 11 ayant un bord supérieur 13 s'étendant dans le prolongement de la face supérieure 6 du corps 2.

L'épaisseur du corps 2, c'est-à-dire la distance séparant sa face supérieure de sa face inférieure est inférieure à la moitié de la hauteur de la face avant 11 du panneau 12, à savoir la distance séparant le bord supérieur 13 de ce panneau de son bord opposé.

Le panneau 12 est quant à lui pourvu de vingt-quatre ports de connexion 14, dont un est visible sur la figure 2, ces ports 14 débouchant dans la moitié inférieure de la face avant 11 en étant régulièrement espacés les uns des autres le long de celle-ci.

Ainsi, lorsque le module 1 est en place comme illustré sur la figure 2, il dépasse de la face avant 11, et ses diodes 9 et ses capteurs sont situés au-dessus des ports 14 et en vis-à-vis de ceux-ci, ces ports 14 étant dégagés et accessibles pour recevoir des câbles de transfert de données non représentés.

Les capteurs situés au droit des ports sont par exemple des capteurs infrarouge ou fonctionnant en lumière visible, ou tout autre solution permettant de détecter la présence physique d'un connecteur enfiché dans le port.

En service, chaque diode 9 est allumée d'une couleur correspondant à l'application du port qu'elle surplombe, et chaque port est surmonté par un capteur apte à détecter s'il est occupé ou libre, c'est-à-dire si un connecteur est ou non enfiché dans ce port.

Le panneau 12 est fixé à deux montants latéraux 16 et 17 d'une armoire par des oreilles 18 et 19 prolongeant chacune de ses extrémités. Chaque oreille comporte ici deux trous dans lesquels sont passées des vis de fixation au montant correspondant non représentées.

Le montage du module 1 selon l'invention consiste en premier lieu à fixer ses deux pattes 3 et 4 aux montants 16 et 17 par-dessus les oreilles 18 et 19, ces pattes comportant elles-mêmes des trous de fixation repérés par 21 à 24, puis à encliqueter chacune des deux extrémités du corps 2 dans la patte correspondante.

Comme visible sur la figure 3, la patte de fixation 3 comporte plus particulièrement une pince 26 constituant sa portion principale, ayant deux ailes 27 et 28 planes parallèles qui sont espacées l'une de l'autre d'une distance correspondant à l'épaisseur du corps 2. Ces deux ailes 27 et 28 planes rectangulaires sont réunies et portées par une base 29 plane et rectangulaire qu'elles prolongent, pour former conjointement avec cette base une pince ayant en section une forme correspondant à la lettre U, agencée pour enserrer une extrémité du corps 2 et s'encliqueter avec celle-ci.

Les ailes parallèles 27 et 28 s'étendent perpendiculairement à la base 29, dont elles prolongent deux bords opposés. Comme visible sur la figure 3, l'aile 27 comporte deux ouvertures ou fenêtres d'encliquetage 31 et 32 destinées à l'encliquetage par engagement d'un ergot 33 dans l'une de ces fenêtres. Cet ergot 33 dépasse de la face supérieure 6 en étant situé dans une région d'extrémité du corps 2, comme visible sur la figure 4.

Complémentairement, l'un des deux bords restants de la base rectangulaire 29 est prolongé par une languette de fixation 34 plane s'étendant en direction opposée aux ailes 27 et 28 par rapport à la base 29. Cette languette 34 est orientée perpendiculairement aux ailes et à la base et est équipée des trous de fixation 21 et 22.

La fixation de la patte 3 au montant 16 consiste à retirer la vis de fixation supérieure de l'oreille 18 prolongeant la face avant 11. La patte 3 est alors positionnée pour que la pince 26 dépasse du montant 16, en plaquant la languette 34 sur l'oreille 18 et en positionnant son trou 22 en vis-à-vis du trou correspondant de cette oreille 18, les ailes 27 s'étendant horizontalement en étant orientées vers l'autre montant 17. La vis qui a été retirée peut alors être engagée à travers les trous de la patte, de l'oreille, et du montant 16 pour être vissée et serrée. La patte 4 est fixée de manière analogue à l'autre montant 17.

Lorsque les pattes 3 et 4 sont montées, le corps 2 du module peut être installé, ce qui consiste à le présenter en vis-à-vis et à distance de la face avant 11 avec ses extrémités en vis-à-vis des pattes 3 et 4. Une pression sur le corps 2 en direction de la face 11 permet d'engager ses extrémités dans les pattes 3 et 4 pour que ces pattes enserrent ces extrémités, et à pousser jusqu'à encliquetage.

Comme représenté sur la figure 5, l'encliquetage de l'extrémité dans la patte 3 est obtenu lorsque l'ergot 33 s'engage dans la fenêtre 31. Il en va de même de l'encliquetage de l'autre extrémité dans la patte 4.

La connexion du corps 2 est assurée au moyen d'une nappe électrique assurant son alimentation électrique et les transferts de données via le gestionnaire central auquel elle est connectée.

A cet effet, et comme visible notamment sur la figure 5, la face supérieure 6 du corps 2 est équipée d'un connecteur femelle 36 en forme de barrette s'étendant sur la majorité de la largeur de cette face supérieure 6 en étant orienté perpendiculairement aux bords principaux de cette face supérieure 6.

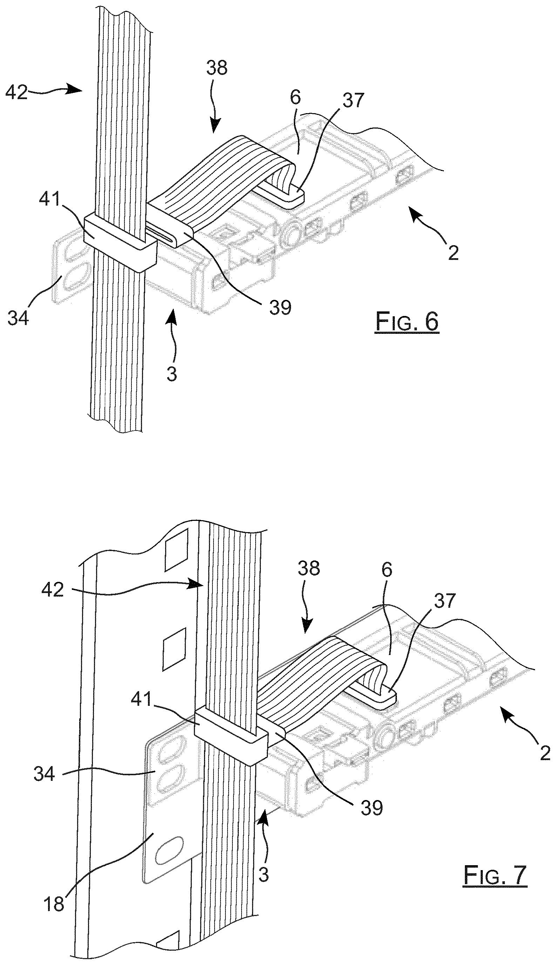

Comme illustré sur les figures 6 et 7, ce connecteur femelle 36 est agencé pour recevoir un connecteur mâle correspondant 37 terminant une extrémité d'une bretelle de connexion 38, cette bretelle ayant à son autre extrémité un autre connecteur 39. Cette bretelle 38 est formée à partir d'une nappe de conducteurs électriques de façon à pouvoir être repliée le long de la face supérieure 6 vers l'extrémité du corps 2 pour pouvoir être connectée par son autre connecteur 39 à un connecteur correspondant 41 d'une nappe principale 42 qui longe le montant 16 pour être elle-même connectée au gestionnaire central.

Le gestionnaire central qui n'est pas représenté sur les figures est un élément au même format que le panneau 12 et que le module 1, par exemple au format dix-neuf pouces, et il est fixé à l'armoire de la même manière que les panneaux, en étant situé par exemple en région supérieure ou inférieure de cette armoire.

Dans l'exemple qui est illustré sur les figures 1 à 7, le module 1 selon l'invention est installé sur un panneau standard de type affleurant, c'est-à-dire dont la face avant 11 est positionnée à affleurement des faces avant des montants 16 et 17.

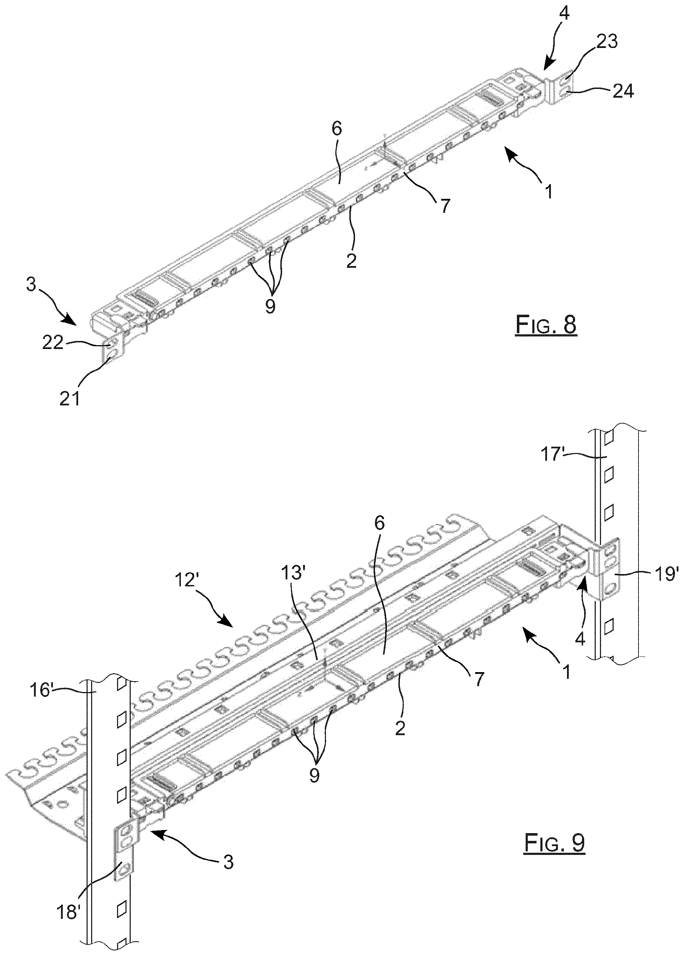

Mais le module selon l'invention est également montable sur un panneau qui est monté en retrait par rapport aux montants latéraux de l'armoire qui le porte, comme sur l'exemple des figures 8 à 12.

Dans cet autre exemple de montage du même module 1 de la figure 8, les mêmes pattes 3 et 4 sont utilisées en inversant simplement d'avant en arrière leur orientation, ce qui permet de fixer le corps 2 contre la face avant 11' d'un autre panneau passif standard 12' qui est monté en retrait par rapport aux montants latéraux 16' et 17' de l'armoire qui le porte.

Comme visible sur la figure 9, ce panneau 12' comporte une face avant 11' dont les extrémités sont prolongées par des oreilles 18' et 19' qui sont décalées par rapport à cette face avant 11' tout en s'étendant parallèlement à la face 11' mais à distance de celle-ci.

C'est la raison pour laquelle le panneau 12' est en retrait par rapport aux montants 16' et 17', c'est-à-dire que sa face avant 11' est décalée vers l'arrière de l'armoire par rapport aux faces avant des montants 16' et 17' par lesquelles il est maintenu grâce aux oreilles 18' et 19'.

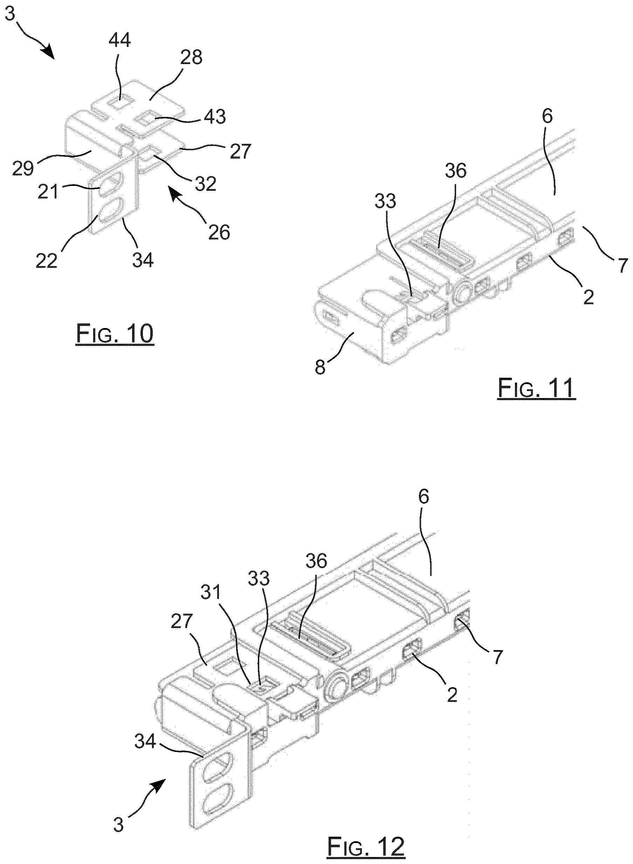

Dans cette autre configuration, les pattes 3 et 4 sont simplement montées de façon inversée par rapport au corps 2, comme illustré sur les figures 10 et 11. Là aussi, la fixation consiste à retirer la vis supérieure de l'oreille 18'. La patte 3 est alors positionnée, mais pour que la pince 26 longe une face latérale interne du montant 16', en plaquant la languette 34 sur l'oreille 18' avec son trou 22 en vis-à-vis du trou correspondant de cette oreille 18', les ailes 27 s'étendant horizontalement et orientées vers l'autre montant 17'. La vis retirée peut alors être engagée dans les trous de la patte, de l'oreille, et du montant 16' pour être serrée. La patte 4 est fixée de manière analogue à l'autre montant 17'.

Le corps 2 du module peut alors être installé en le présentant en vis-à-vis et à distance de la face avant 11' avec ses extrémités en vis-à-vis des pattes 3 et 4, une pression sur le corps 2 vers la face 11' permet alors d'encliqueter ses extrémités dans les pattes 3 et 4, ce qui correspond à la situation de la figure 12. L'encliquetage de l'extrémité du corps 2 dans la patte 3 est alors obtenu lorsque l'ergot 33 s'engage dans la fenêtre 43 de l'aile 28 qui comporte elle aussi deux ouvertures ou fenêtres d'encliquetage 43 et 44, tout comme l'aile 27. L'encliquetage de l'autre extrémité dans la patte 4 est obtenu de la même manière.

Dans les exemples qui ont été décrits, les mêmes pattes 3 et 4 sont utilisées pour assurer le montage du corps 2 selon deux configurations différentes. Pour étendre l'adaptabilité du module selon l'invention, une famille de différentes pattes ayant des formes différentes adaptées à la majorité des montages courants peut être prévue pour rendre le module montable sur à peu près tout type de panneau standard.

En pratique, chaque module peut être vendu sous la forme d'un ensemble comportant un corps 2 et plusieurs paires de pattes différentes adaptées à la majorité des situations.

Dans cette autre configuration, le corps du module est branché de la même manière que dans le premier exemple au gestionnaire central de l'armoire, c'est-à-dire avec des nappes de conducteurs ou câbles plats assurant à la fois son alimentation électrique et le transfert de données.

Dans un cas comme dans l'autre, les données transférées sont les informations de couleur d'illumination de chaque diode, correspondant à l'application qui est associée à chaque port ou qui correspond à un code d'action communiqué à une personne faisant face à l'armoire. Ces informations sont transmises par le gestionnaire central au corps 2, et les signaux issus des capteurs du module sont envoyés par le module au gestionnaire central.

## Revendications

1. Module intelligent destiné à équiper un panneau passif (12; 12') porté par deux montants latéraux (16, 17 ; 16', 17') d'une armoire de brassage, le panneau passif (12 ; 12') comportant une face avant (11 ; 11') pourvue de ports de connexion (14), ce module (1) comprenant un corps (2) en forme de réglette ainsi que deux pattes de fixation (3, 4), le corps comportant une série de diodes (9) et une série de capteurs de présence, chaque patte de fixation (3, 4) comportant au moins un trou (21-24) permettant de la fixer rigidement à un montant (16, 17 ; 16', 17') au moyen d'une vis, chaque extrémité du corps (2) étant rigidement solidarisable à une patte de fixation (3, 4) en étant enserré et/ou encliqueté par cette patte (3, 4).

2. Module selon la revendication 1, dans lequel chaque patte (3, 4) comporte une base (29) prolongée d'une part par deux ailes (27, 28) formant une pince (26) pour enserrer une extrémité du corps (2) et d'autre part par une languette (34) s'étendant en direction opposée aux ailes (27, 28) par rapport à la base (29) en étant perpendiculaire aux ailes (27, 28) et à la base (29), cette languette (34) comportant au moins un trou de fixation (21-24).

3. Module selon la revendication 2, dans lequel au moins une aile (27, 28) comporte au moins une fenêtre d'encliquetage (31, 32), et dans lequel une face (6) du corps (2) est pourvue d'un ergot (33) s'engageant dans cette fenêtre (31, 32) pour assurer un encliquetage de la patte (3, 4) sur l'extrémité du corps (2).

4. Module selon la revendication 3, dans lequel le corps (2) comporte à l'une de ses faces (6) un connecteur (36) destiné à recevoir un câble (38) de transfert de données et d'alimentation électrique.

5. Module selon la revendication 4, dans lequel le connecteur (36) est destiné à recevoir un câble (38) plat du type nappe de conducteurs électriques.

6. Module selon l'une des revendications précédentes comportant un corps (2) associé avec plusieurs paires de pattes de fixation (3, 4) de formes différentes pour permettre son montage selon différentes configurations.

7. Système intelligent pour armoire de brassage comprenant plusieurs modules (1) selon l'une des revendications précédentes et un gestionnaire central destiné à être connecté à chaque module (1).

## Patentansprüche

1. Intelligentes Modul, das dazu bestimmt ist, ein passives Panel (12; 12') auszustatten, das von zwei seitlichen Pfosten (16, 17; 16', 17') eines Patch-Schranks getragen wird, wobei das passive Panel (12; 12') eine mit Anschlussbuchsen (14) versehene Vorderseite (11; 11') umfasst, wobei dieses Modul (1) einen streifenförmigen Körper (2) sowie zwei Befestigungslaschen (3, 4) umfasst, wobei der Körper eine Reihe Dioden (9) und eine Reihe Anwesenheitssensoren umfasst, wobei jede Befestigungslasche (3, 4) mindestens ein Loch (21-24) umfasst, das ihre feste Befestigung an einem Pfosten (16, 17; 16', 17') mittels einer Schraube ermöglicht, wobei jedes Ende des Körpers (2) starr an einer Befestigungslasche (3, 4) befestigt ist, indem es durch diese Lasche (3, 4) geklemmt und/oder eingerastet wird.

2. Modul nach Anspruch 1, wobei jede Lasche (3, 4) eine Basis (29) umfasst, die einerseits durch zwei Flügel (27, 28) verlängert ist, die eine Klemme (26) zum Ergreifen eines Endes des Körpers (2) bilden, und andererseits durch eine Zunge (34), die sich in entgegengesetzter Richtung zu den Flügeln (27, 28) relativ zur Basis (29) erstreckt, während sie senkrecht zu den Flügeln (27, 28) und zur Basis (29) steht, wobei diese Zunge (34) mindestens ein Befestigungsloch (21-24) umfasst.

3. Modul nach Anspruch 2, bei dem mindestens ein Flügel (27, 28) mindestens ein Rastfenster (31, 32) aufweist und bei dem eine Seite (6) des Körpers (2) mit einer in dieses Fenster (31, 32) eingreifenden Nase (33) versehen ist, um sicherzustellen, dass die Lasche (3, 4) am Ende des Körpers (2) einrastet.

4. Modul nach Anspruch 3, wobei der Körper (2) an einer seiner Seiten (6) einen Verbinder (36) umfasst, der dazu bestimmt ist, ein Datenübertragungs- und Stromversorgungskabel (38) aufzunehmen.

5. Modul nach Anspruch 4, wobei der Verbinder (36) dazu bestimmt ist, ein Flachkabel (38) des Blatttyps von elektrischen Leitern aufzunehmen.

6. Modul nach einem der vorhergehenden Ansprüche das einen Körper (2) umfasst, dem mehrere Paare Befestigungslaschen (3, 4) unterschiedlicher Form zugeordnet sind, um seine Montage in verschiedenen Konfigurationen zu ermöglichen.

7. Intelligentes System für einen Patch-Schrank, das mehreren Modulen (1) nach einem der vorhergehenden Ansprüche und eine zentrale Verwaltungseinrichtung, die mit jedem Modul (1) verbunden werden soll, umfasst.

## Claims

1. A smart module for equipping a passive panel (12; 12') carried by two side posts (16, 17; 16', 17') of a cabling closet, the passive panel (12; 12') including a front face (11; 11') provided with connection ports (14), this module (1) comprising a small-ruler shaped body (2) as well as two fastening lugs (3, 4), the body including a series of diodes (9) and a series of presence sensors, each fastening lug (3, 4) including at least one hole (21-24) enabling it to be rigidly fastened to a post (16, 17; 16', 17') by means of a screw, each end of the body (2) being rigidly securable to a fastening lug (3, 4) by being sandwiched and/or snap fitted by this lug (3, 4).

2. The module according to claim 1, wherein each lug (3, 4) includes a base (29) extending on the one hand to two wings (27, 28) forming a clamp (26) to sandwich an end of the body (2) and on the other hand to a tab (34) extending in a direction opposite to the wings (27, 28) relative to the base (29) by being perpendicular to the wings (27, 28) and to the base (29), this tab (34) including at least one fastening hole (21-24).

3. The module according to claim 2, wherein at least one wing (27, 28) includes at least one snap fit window (31, 32), and wherein a face (6) of the body (2) is provided with a spigot (33) engaging into this window (31, 32) to ensure snap fitting of the lug (3, 4) to the end of the body (2).

4. The module according to claim 3, wherein the body (2) includes at one of its faces (6) a connector (36) for receiving a data transfer and power supply cable (38).

5. The module according to claim 4, wherein the connector (36) is for receiving a flat cable (38) of the electrical conductor ribbon type.

6. The module according to one of the preceding claims, including a body (2) associated with several pairs of fastening lugs (3, 4) with different shapes to enable it to be mounted according to different configurations.

7. A smart system for a cabling closet comprising several modules (1) according to one of the preceding claims and a central manager for being connected to each module (1).
